# FASCICULE DE BREVET EUROPEEN

(11) **EP 3 190 334 B1**
(45) Date de publication et mention de la délivrance du brevet: **08.09.2021**
(21) Numéro de dépôt: 17150330.3
(22) Date de dépôt: 05.01.2017
(51) Int. Cl.: F21S 43/14, H05K 1/02, H01L 25/075, F21Y 107/50, F21Y 113/13, F21S 43/19, F21S 43/237, F21S 43/249, F21S 45/47, H05K 1/18

(54) **MODULE LUMINEUX POUR VÉHICULE AUTOMOBILE COMPRENANT DEUX TYPES DE SOURCES LUMINEUSES**
LICHTMODUL FÜR KRAFTFAHRZEUG MIT ZWEI TYPEN VON LICHTQUELLEN
LIGHTING MODULE FOR VEHICLE COMPRISING TWO KINDS OF LIGHT SOURCES

(30) Priorité: 11.01.2016 FR 1650201
(43) Date de publication de la demande: 12.07.2017
(73) Titulaire: Valeo Iluminacion, 23600 Martos (ES)
(72) Inventeur: ILLAN, Antonio Domingo, 23600 MARTOS (ES); ROLDAN, Jose-David, 23680 Alcalá la Real (ES); MARTINEZ-PEREZ, Jose-Ramon, 23600 MARTOS (ES); PENA, Miguel-Angel, 18260 ILLORA (ES); CALMAESTRA, Manuel, 23600 MARTOS (ES)

(56) Documents cités:
- EP-A1- 1 860 707
- EP-A1- 2 161 494
- EP-A1- 2 270 389
- EP-A1- 2 826 668
- WO-A1-2015/092034
- FR-A1- 2 966 286
- JP-A- 2002 368 279
- JP-A- 2011 090 903
- US-A1- 2006 245 188
- US-A1- 2009 116 252

## Description

L'invention a trait au domaine de l'éclairage et de la signalisation lumineuse, notamment pour véhicule automobile.

Dans le domaine de l'éclairage et de la signalisation lumineuse pour véhicules automobiles, il devient de plus en plus courant d'utiliser des sources lumineuses à composants semi-conducteurs électroluminescents, par exemple des diodes électroluminescentes, LED. Un composant LED émet des rayons lumineux lorsqu'une tension d'une valeur au moins égale à une valeur seuil appelée tension directe est appliquée à ses bornes.

De manière connue, une ou plusieurs LEDs d'un module lumineux pour un véhicule automobile sont alimentées par le biais de moyens de pilotage de l'alimentation, qui comprennent des circuits convertisseurs. Les moyens de pilotage de l'alimentation sont configurés pour convertir un courant électrique d'une première intensité, par exemple fourni par une source de courant du véhicule automobile, telle qu'une batterie, en un courant de charge ayant une deuxième intensité, différente de la première.

La lumière émise par une LED peut de manière connue être couplée dans un guide lumineux ayant une face d'entrée, par laquelle les rayons lumineux émis par la LED entrent dans le guide, et une face d'entrée physiquement déportée par rapport à la face d'entrée, par laquelle les rayons lumineux ressortent du guide lumineux. Entre la face d'entrée et la face de sortie, les rayons lumineux sont guidés à l'intérieur du guide lumineux, typiquement à l'aide d'éléments réfléchissants disposés à l'intérieur du guide lumineux.

Des LEDs différentes, capables par exemple d'émettre de la lumière de couleur ou d'intensité différente, peuvent être utilisés pour réaliser des fonctions lumineuses différentes d'un véhicule automobile au sein d'un même dispositif lumineux. Il peut par exemple s'agir des fonctions feux de route, ou feux indicateurs de direction. Ces LEDs implémentant des fonctions lumineuses différentes peuvent néanmoins être alimentées et commandées par des circuits d'alimentation et de commande communs, réduisant ainsi la nécessité de prévoir des circuits électroniques dédiés. Cependant, le couplage de la lumière produite pour différentes fonctions lumineuses vers différents guides lumineux reste une contrainte d'encombrement spatial lors de la conception de dispositifs lumineux pour un véhicule automobile.

Il est à noter que différents types de LEDs logées sur un même circuit imprimé produisent des quantités de chaleur différentes lors de leur fonctionnement, et que la chaleur produite peut également dépendre de la fonction lumineuse réalisée par les LEDs. En effet, un feu indicateur de direction ou clignotant n'émet de la lumière que de manière intermittente. Il en est de même pour la production de chaleur y associée. Cependant, une LED réalisant un feu diurne à forte luminosité produit une quantité de chaleur plus importante. En général, des éléments de dissipation de chaleur sont utilisés pour éviter un sur-échauffement des LEDs. Afin de garantir une dissipation thermique efficace, ces éléments sont de manière connue souvent surdimensionnés en fonction des LEDs du dispositif lumineux qui produisent le plus de chaleur. Ceci engendre une perte d'espace et d'efficacité supplémentaire.

Un module lumineux comprenant deux sources lumineuses de types différents et un guide de lumière est connu du document EP 2 270 389 A1.

L'invention a pour objectif de proposer une solution palliant à au moins un des problèmes susmentionnés. Plus particulièrement, l'invention a pour objectif de proposer un module lumineux impliquant plusieurs types de sources lumineuses.

L'invention, définie dans la revendication 1, a pour objet un module lumineux pour un véhicule automobile. Le module lumineux comprend un support ainsi qu'un circuit imprimé abritant au moins une source lumineuse d'un premier type. C'est-à-dire que la source lumineuse d'un premier type est montée sur le circuit imprimé. Le circuit imprimé est logé sur le support. Le module lumineux est remarquable en ce qu'il comprend au moins une source lumineuse d'un deuxième type logée directement sur le support. L'arrangement des sources lumineuses est tel que les sources lumineuses du premier type et du deuxième type sont aptes à émettre des rayons lumineux en direction d'une face d'entrée d'un même guide lumineux du module.

De préférence, le module peut comprendre une pluralité de types de sources lumineuses plus importante, par exemple trois, quatre ou plus de types de sources lumineuses. Chaque type de source lumineuse au-delà des deux types de sources lumineuses peut être logé soit sur un circuit imprimé, comme le premier type de sources lumineuses, soit directement sur ledit support, comme le deuxième type de sources lumineuses.

De préférence, le circuit imprimé peut comprendre au moins une fenêtre traversante, donnant accès au support. La source lumineuse du deuxième type peut de préférence être logée sur le support à l'endroit correspondant à la fenêtre du circuit imprimé. Alternativement, le circuit imprimé peut comprendre un bord, et la source lumineuse du deuxième type peut être logée sur le support au voisinage dudit bord.

De préférence, les sources lumineuses du deuxième type peuvent être reliées électriquement au circuit imprimé.

La liaison entre la source lumineuse du deuxième type et le circuit imprimé peut de préférence être réalisée par pontage par un fil métallique. Alternativement, le liaison peut être réalisée par pontage par un ruban métallique.

De manière préférée, les sources lumineuses du premier et du deuxième type peuvent être alimentées en électricité par des moyens de pilotage de l'alimentation communs. Les moyens de pilotage peuvent de préférence être agencés pour alimenter sélectivement les sources lumineuses du premier et du deuxième type. Le circuit imprimé peut de préférence être fixé au support par sertissage ou par collage.

De préférence, la source lumineuse du deuxième type peut être fixée au support par collage.

Le collage peut de préférence être réalisé à l'aide d'une colle à conductivité thermique.

De manière préférée, le support peut comprendre des moyens de dissipation thermique du module. Le support peut de préférence comprendre une base supportant la source lumineuse du deuxième type, les moyens de dissipation thermique pouvant par exemple comprendre des ailettes s'étendant perpendiculairement à la base.
De préférence, le support comprend une surface généralement plane d'un élément de dissipation thermique du module. Les moyens de dissipation thermique peuvent de préférence comprendre un radiateur en matière thermiquement conductrice.

Les moyens de dissipation thermique peuvent préférentiellement comprendre de l'Aluminium.

La source lumineuse du premier type peut de préférence être apte à émettre de la lumière d'une première couleur, par exemple la couleur ambre. La source lumineuse du deuxième type peut de préférence être apte à émettre de la lumière d'une deuxième couleur, par exemple la couleur blanche.

De préférence, la source lumineuse du premier type peut être destinée à réaliser une première fonction lumineuse, par exemple la fonction indicateur de direction. De préférence, la source lumineuse du deuxième type peut être destinée à réaliser une deuxième fonction lumineuse, par exemple la fonction feux diurnes.

Le guide lumineux peut de préférence être agencé de sorte à ce que la lumière se rapportant aux première et deuxième fonctions lumineuses sorte par la face de sortie commune. Avantageusement, la source lumineuse du deuxième type est destinée à réaliser en outre une troisième fonction lumineuse, par exemple la fonction feu de position, lorsqu'elle est sous-alimentée.

Les sources lumineuses peuvent de préférence être des sources lumineuses à élément semi-conducteur, par exemple des sources lumineuses électroluminescentes, LED.

De préférence, les sources lumineuses et le guide lumineux peuvent être arrangés de façon à ce que la source lumineuse du premier type est apte à émettre des rayons lumineux en direction d'une première face d'entrée du guide lumineux, et de façon à ce que la source lumineuse du deuxième type est apte à émettre des rayons lumineux en direction d'une deuxième face d'entrée, différente de la première face d'entrée, du même guide lumineux.

Alternativement, les sources lumineuses et le guide lumineux peuvent être arrangés de façon à ce que les sources lumineuses du premier et du deuxième type sont aptes à émettre des rayons lumineux en direction d'une même face d'entrée du guide lumineux.

Les mesures de l'invention sont intéressantes en ce que des sources lumineuses de plusieurs de types différents, correspondant par exemple à des diodes électroluminescentes, LEDs, de couleurs différentes et réalisant des fonctions lumineuses différentes d'un véhicule automobile, peuvent être disposées de manière physiquement proche dans un module lumineux. Ceci présente l'avantage que les rayons lumineux émis par les différents types de LEDs peuvent être couplés dans un guide lumineux commun, réduisant ainsi le besoin de mettre à disposition des guides lumineux individuels par fonction lumineuse. Selon un mode de réalisation préféré, des LEDs produisant une quantité de chaleur importante, correspondant par exemple aux LEDs réalisant la fonction feux diurnes d'un véhicule automobile, sont logées directement sur un élément de dissipation thermique, tandis que des LEDs à faible production de chaleur sont logées sur un circuit imprimé supporté par l'élément de dissipation thermique. En prévoyant une fenêtre pré-coupée dans la surface du circuit imprimé, les deux types de LEDs en question peuvent être physiquement proches. En prévoyant en plus une connexion électrique de type pontage « wire bonding », toutes les LEDs peuvent être alimentées électriquement par des moyens d'alimentation électrique communs.

D'autres caractéristiques et avantages de la présente invention seront mieux compris à l'aide de la description et des dessins parmi lesquels :
- la figure 1 montre une illustration schématique d'une coupe latérale à travers un module selon un mode préférentiel de l'invention ;
- la figure 2 montre une illustration schématique d'une vue d'en haut d'un module selon un mode préférentiel de l'invention ;

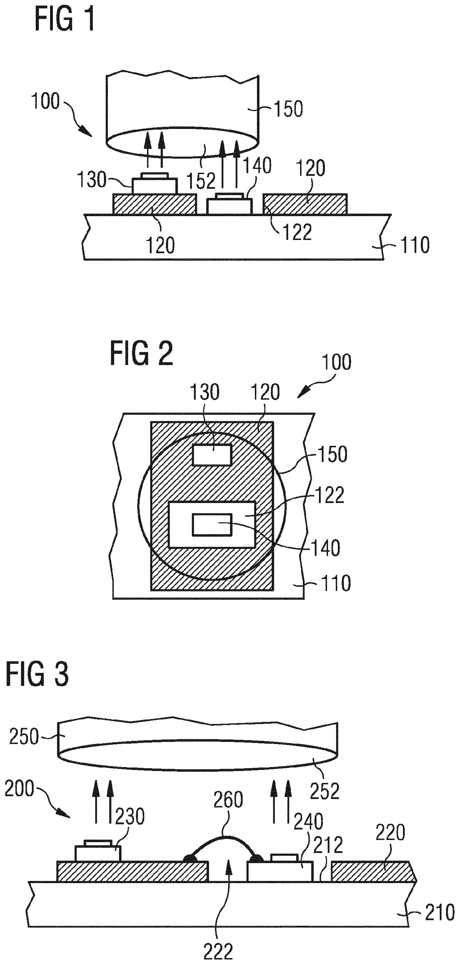

- la figure 1 montre une illustration schématique d'une coupe latérale à travers un module selon un mode préférentiel de l'invention.

Dans la description qui suit, des numéros de référence similaires seront utilisés pour décrire des concepts similaires à travers des modes de réalisation différents de l'invention. Ainsi, les numéros de référence 100, 200 décrivent un module lumineux dans deux modes de réalisation différents conformes à l'invention.

Sauf indication spécifique du contraire, des caractéristiques techniques décrites en détail pour un mode de réalisation donné peuvent être combinées aux caractéristiques techniques décrites dans le contexte d'autres modes de réalisation décrits à titre exemplaire et non limitatif.

Les éléments montrés sur les dessins ne sont pas à l'échelle et sont simplifiés pour augmenter la clarté de l'exposé.

La figure 1 montre, dans une coupe latérale schématisée, un module lumineux 100 selon l'invention, dans lequel uniquement les composants qui ont un rapport direct avec l'invention sont montrés. Un circuit imprimé 120 abrite un circuit électronique comprenant en outre au moins une source lumineuse 130. La source lumineuse 130 est d'un premier type et il s'agit par exemple d'une diode électroluminescente, LED.

Le circuit imprimé est logé sur un support 110 du module lumineux 100. Au moins une source lumineuse, par exemple de type LED, d'un deuxième type 140, est disposée directement sur une surface du support 110, et non pas sur le circuit imprimé 120. Le circuit imprimé comprend une fenêtre traversante 122 ou une baie excisée sur un de ses bords, de façon à ce que le substrat du circuit imprimé 120 encadre au moins partiellement les sources lumineuses du deuxième type 140. Les sources lumineuses du premier et du deuxième type peuvent par exemple se distinguer par la couleur de la lumière émise, ou par la fonction lumineuse qu'elles sont destinées à réaliser au sein du module. Des combinaisons de ces distinctions et d'autres attributs distinctifs sont envisageables sans pour autant sortir du cadre de l'invention.

Le module comprend également un guide lumineux 150 qui comprend une face d'entrée 152, destinée à coupler des rayons lumineux y incidents, et à les guider vers une face de sortie non-illustrée. De tels guides lumineux sont connus dans l'art, ils peuvent par exemple comprendre des faces d'entrées multiples. Le guidage des rayons lumineux à l'intérieur du guide se fait moyennant le principe de réflexion totale sur les parois internes du guide. Un guide lumineux permet notamment d'émettre des rayons lumineux à un endroit déporté de la source lumineuse dont ils sont issus. Selon l'invention, l'arrangement des sources lumineuses est tel que les sources lumineuses du premier type 130, logées sur le circuit imprimé 120, et les sources lumineuses du deuxième type 140, logées sur le support 110, sont aptes à émettre des rayons lumineux en direction d'une face d'entrée 152 du guide lumineux 150.

Le circuit imprimé 120 est de préférence un circuit imprimé à substrat généralement plan et rigide, PCB (« printed circuit board »). Le substrat est de manière connue façonné à partir d'une résine époxy. La fenêtre ou baie 122 peut être intégrée lors du moulage par injection du substrat, ou elle peut alternativement être réalisée par enlèvement de la matière correspondante, une fois que le substrat a été produit. Le circuit imprimé peut alternativement être un circuit imprimé à substrat flexible, FPCB (« printed circuit board ») ou un circuit imprimé à géométrie complexe de type MID (« molded interconnect device »).

La vue d'en haut de la figure 2 montre l'exemple d'une fenêtre 122 entourant une source lumineuse 140 du deuxième type, disposée sur le support 110. De manière avantageuse, le support 110 est un élément de dissipation thermique, préférentiellement en Aluminium, et comprend une surface généralement plane 122 sur laquelle le circuit imprimé 120 et les sources lumineuse 140 du deuxième type sont fixées. La fixation est par exemple réalisée à l'aide d'une colle thermique. Le circuit imprimé peut alternativement être fixé à l'élément de dissipation thermique par sertissage, moyennant des pions de sertissages prévus à cet effet sur la surface 122. L'élément de dissipation thermique est par exemple un radiateur.

Dans un mode de réalisation préféré non limitatif, les sources lumineuses du premier type 130 sont des LEDs pouvant émettre de la lumière de couleur ambre. Ces sources réalisent la fonction clignotant, ou indicateur de direction, d'un véhicule automobile et ne fonctionnent donc que de manière intermittente, produisant ainsi relativement peu de chaleur. Les sources lumineuses du deuxième type 140 sont des LEDs pouvant émettre de la lumière blanche. Ces sources réalisent par exemple la fonction feux diurnes et produisent une chaleur plus importante pendant des périodes prolongées. L'invention permet de disposer ces sources 140 en contact direct avec l'élément de dissipation thermique 110, garantissant ainsi un bon échange thermique, tandis que tous les autres composants électroniques peuvent être logés sur le circuit imprimé, ce qui facilite leur mise en place et la production du module 100. La disposition des deux types de sources lumineuses 130, 140 peut néanmoins être physiquement rapprochée, de manière à ce que les rayons lumineux issus des deux types de sources lumineuses puissent être couplés dans un même guide lumineux même si l'aire de sa face d'entrée n'est pas importante. Ceci présente des avantages au niveau du gain d'espace au sein du module 100, ceci permet de réaliser des designs intéressants. En effet selon la fonction lumineuse choisie, une même face de sortie du guide lumineux peut émettre soit des rayons lumineux blancs, soit de rayons lumineux de couleur ambre.

Dans un mode de réalisation préféré, les sources lumineuses du premier et du deuxième type 130, 140 sont alimentées en électricité par un circuit de pilotage de l'alimentation commun. Les composants électroniques réalisant ce circuit peuvent être logés sur le circuit imprimé 110, ou sur un circuit imprimé physiquement déporté par rapport au circuit imprimé 110 et y reliés par des fils conducteurs. Afin de réaliser cette configuration, les sources lumineuses 140 sont avantageusement reliées électriquement à un circuit électronique logé sur le circuit imprimé 110.

La figure 3 montre un mode de réalisation particulièrement préféré du module 200 selon l'invention en coupe latérale schématisée. Un circuit imprimé 220 abrite un circuit électronique comprenant en outre au moins une source lumineuse 230. Le circuit imprimé est logé sur un support 210 du module lumineux 200. Au moins une source lumineuse d'un deuxième type 240, est disposée directement sur une surface 212 du support 210. Le circuit imprimé comprend une fenêtre traversante 222, de façon à ce que le substrat du circuit imprimé 220 encadre au moins partiellement les sources lumineuses du deuxième type 240. Le module comprend également un guide lumineux 250 qui comprend une face d'entrée 252, destinée à coupler des rayons lumineux y incidents, et à les guider

Les diodes électroluminescentes 240 du deuxième type sont reliées électriquement au circuit électronique du circuit imprimé 210 via des fils métalliques 260 formant des ponts entre des zones de contact du circuit imprimé d'une part, et des zones de contact correspondantes des diodes. Ces fils 260 sont soudés à ces zones par ultrasons. Il s'agit de la technologie communément désignée par l'expression anglo-saxonne «wire-bonding », ou encore par l'expression « câblage par fil » ou « pontage ». C'est une technique couramment utilisée pour effectuer les connexions électriques entre le boîtier et la puce d'un circuit intégré. Le câblage est simplement réalisé par un fil (ou pont) soudé entre les deux plots de connexion prévus à cet usage sur chacun des éléments. La soudure est généralement réalisée par ultrasons. Le matériau du fil est de l'aluminium, de l'or ou du cuivre. Le diamètre du fil peut être compris entre 75µm et 250µm.

La technique du wire-bonding facilite la mise en place des différents composants lors de la production du module lumineux 200. Lors d'une première étape, les sources lumineuses du deuxième type 240 sont disposées et fixées sur le support 210, qui est de préférence un dissipateur thermique. Ensuite, le circuit imprimé 210 préalablement peuplé de composants électroniques, y compris des sources lumineuses du premier type 230, est disposé et fixé sur le support 210. La disposition et telle que la fenêtre ou baie traversante 222 du circuit imprimé vient encadrer l'emplacement des sources lumineuses 240 du deuxième type. Ensuite, la connexion électrique entre les sources 240 du deuxième type et le circuit imprimé 220 est réalisée par pontage.

## Revendications

1. Module lumineux (100, 200) pour un véhicule automobile, comprenant un guide lumineux (150, 200), au moins une source lumineuse à composants semi-conducteurs électroluminescents d'un premier type (130, 230), au moins une source lumineuse à composants semi-conducteurs électroluminescents d'un deuxième type (140, 240), l'arrangement des sources lumineuses étant tel que les sources lumineuses du premier type (130, 230) et du deuxième type (140, 240) sont aptes à émettre des rayons lumineux en direction d'une face d'entrée (152, 252) du guide lumineux (150, 200), comprenant en outre un support (110, 210) ainsi qu'un circuit imprimé (120, 220) logé sur le support (110, 210), la au moins une source lumineuse du premier type (130, 230) étant montée sur le circuit imprimé (120, 220),
**caractérisé en ce que** la au moins une source lumineuse du deuxième type (140, 240) est logée directement sur le support (110, 210).

2. Module lumineux selon la revendication 1, **caractérisé en ce que** le circuit imprimé (120, 220) comprend au moins une fenêtre traversante (122, 222), donnant accès au support (110, 210), et **en ce que** la source lumineuse du deuxième type (140, 240) est logée sur le support à l'endroit correspondant à la fenêtre du circuit imprimé.

3. Module lumineux selon une des revendications 1 ou 2, **caractérisé en ce que** la source lumineuse du deuxième type (240) est reliée électriquement au circuit imprimé (220).

4. Module lumineux selon la revendication 3, **caractérisé en ce que** la liaison entre la source lumineuse du deuxième type (240) et le circuit imprimé (220) est réalisée par pontage par un fil métallique (260).

5. Module lumineux selon une des revendications 1 à 4, **caractérisé en ce que** les sources lumineuses du premier et du deuxième type (230, 240) sont alimentées en électricité par des moyens de pilotage de l'alimentation communs.

6. Module lumineux selon une des revendications 1 à 5, **caractérisé en ce que** le circuit imprimé (120, 220) est fixé au support (110, 210) par sertissage ou par collage.

7. Module lumineux selon une des revendications 1 à 6, **caractérisé en ce que** la source lumineuse du deuxième type (140, 240) est fixée au support (110, 210) par collage.

8. Module lumineux selon une des revendications 6 ou 7, **caractérisé en ce que** le collage est réalisé à l'aide d'une colle à conductivité thermique.

9. Module lumineux selon une des revendications 1 à 8, **caractérisé en ce que** le support (110, 210) comprend des moyens de dissipation thermique du module.

10. Module lumineux selon la revendication 9, **caractérisé en ce que** les moyens de dissipation thermique comprennent de l'Aluminium.

11. Module lumineux selon une des revendications 1 à 10, **caractérisé en ce que** la source lumineuse du premier type (130, 230) est apte à émettre de la lumière d'une première couleur, par exemple la couleur ambre, et **en ce que** la source lumineuse du deuxième type (140, 240) est apte à émettre de la lumière d'une deuxième couleur, par exemple la couleur blanche.

12. Module lumineux selon une des revendications 1 à 11, **caractérisé en ce que** la source lumineuse du premier type (130, 230) est destinée à réaliser une première fonction lumineuse, par exemple la fonction indicateur de direction, et **en ce que** la source lumineuse du deuxième type (140, 240) est destinée à réaliser une deuxième fonction lumineuse, par exemple la fonction feux diurnes.

13. Module lumineux selon une des revendications 1 à 12, **caractérisé en ce que** les sources lumineuses (130, 140 ; 230, 240) sont des sources lumineuses à élément semi-conducteur, par exemple des sources lumineuses électroluminescentes, LED.

14. Module lumineux selon une des revendications 1 à 13, **caractérisé en ce que** les sources lumineuses et le guide lumineux sont arrangés de façon à ce que la source lumineuse du premier type est apte à émettre des rayons lumineux en direction d'une première face d'entrée du guide lumineux, et de façon à ce que la source lumineuse du deuxième type est apte à émettre des rayons lumineux en direction d'une deuxième face d'entrée, différente de la première face d'entrée, du même guide lumineux.

15. Module lumineux selon une des revendications 1 à 13, **caractérisé en ce que** les sources lumineuses (130,140 ; 230, 240) et le guide lumineux (150, 250) sont arrangés de façon à ce que les sources lumineuses du premier et du deuxième type sont aptes à émettre des rayons lumineux en direction d'une même face d'entrée (152, 252) du guide lumineux.

## Patentansprüche

1. Lichtmodul (100, 200) für ein Kraftfahrzeug, umfassend einen Lichtleiter (150, 200), mindestens eine Lichtquelle mit elektrolumineszenten Halbleiterbauelementen eines ersten Typs (130, 230), mindestens eine Lichtquelle mit elektrolumineszenten Halbleiterbauelementen eines zweiten Typs (140, 240), wobei die Anordnung der Lichtquellen dergestalt ist, dass die Lichtquellen des ersten Typs (130, 230) und des zweiten Typs (140, 240) geeignet sind, Lichtstrahlen in Richtung einer Eintrittsseite (152, 252) des Lichtleiters (150, 200) auszusenden, umfassend ferner einen Träger (110, 210) sowie eine Leiterplatte (120, 220), die auf dem Träger (110, 210) gelagert ist, wobei die mindestens eine Lichtquelle des ersten Typs (130, 230) auf der Leiterplatte (120, 220) angebracht ist, **dadurch gekennzeichnet, dass** die mindestens eine Lichtquelle des zweiten Typs (140, 240) direkt auf dem Träger (110, 210) gelagert ist.

2. Lichtmodul nach Anspruch 1, **dadurch gekennzeichnet, dass** die Leiterplatte (120, 220) mindestens ein durchgehendes Fenster (122, 222) umfasst, das Zugang zum Träger (110, 210) bietet, und dass die Lichtquelle des zweiten Typs (140, 240) auf dem Träger an der Stelle gelagert ist, die dem Fenster der Leiterplatte entspricht.

3. Lichtmodul nach einem der Ansprüche 1 oder 2, **dadurch gekennzeichnet, dass** die Lichtquelle des zweiten Typs (240) mit der Leiterplatte (220) elektrisch verbunden ist.

4. Lichtmodul nach Anspruch 3, **dadurch gekennzeichnet, dass** die Verbindung zwischen der Lichtquelle des zweiten Typs (240) und der Leiterplatte (220) mit einer Drahtbrücke (260) ausgeführt ist.

5. Lichtmodul nach einem der Ansprüche 1 bis 4, **dadurch gekennzeichnet, dass** die Lichtquellen des ersten und des zweiten Typs (230, 240) über gemeinsame Mittel zur Ansteuerung der Spannungsversorgung mit Strom versorgt werden.

6. Lichtmodul nach einem der Ansprüche 1 bis 5, **dadurch gekennzeichnet, dass** die Leiterplatte (120, 220) am Träger (110, 210) durch Crimpen oder durch Kleben befestigt ist.

7. Lichtmodul nach einem der Ansprüche 1 bis 6, **dadurch gekennzeichnet, dass** die Lichtquelle des zweiten Typs (140, 240) am Träger (110, 210) durch Kleben befestigt ist.

8. Lichtmodul nach einem der Ansprüche 6 oder 7, **dadurch gekennzeichnet, dass** das Kleben mithilfe eines Klebstoffs mit Wärmeleitfähigkeit ausgeführt wird.

9. Lichtmodul nach einem der Ansprüche 1 bis 8, **dadurch gekennzeichnet, dass** der Träger (110, 210) Mittel zur Wärmeableitung vom Modul umfasst.

10. Lichtmodul nach Anspruch 9, **dadurch gekennzeichnet, dass** die Mittel zur Wärmeableitung Aluminium umfassen.

11. Lichtmodul nach einem der Ansprüche 1 bis 10, **dadurch gekennzeichnet, dass** die Lichtquelle des ersten Typs (130, 230) geeignet ist, Licht mit einer ersten Farbe auszusenden, beispielsweise der Farbe Bernstein, und dass die Lichtquelle des zweiten Typs (140, 240) geeignet ist, Licht mit einer zweiten Farbe auszusenden, beispielsweise der Farbe Weiß.

12. Lichtmodul nach einem der Ansprüche 1 bis 11, **dadurch gekennzeichnet, dass** die Lichtquelle des ersten Typs (130, 230) dazu bestimmt ist, eine erste Lichtfunktion auszuführen, beispielsweise die Funktion Blinklicht, und dass die Lichtquelle des zweiten Typs (140, 240) dazu bestimmt ist, eine zweite Lichtfunktion auszuführen, beispielsweise die Funktion Tagfahrlicht.

13. Lichtmodul nach einem der Ansprüche 1 bis 12, **dadurch gekennzeichnet, dass** die Lichtquellen (130, 140; 230, 240) Lichtquellen mit Halbleiterelement sind, beispielsweise elektrolumineszente Lichtquellen, LED.

14. Lichtmodul nach einem der Ansprüche 1 bis 13, **dadurch gekennzeichnet, dass** die Lichtquellen und der Lichtleiter so angeordnet sind, dass die Lichtquelle des ersten Typs geeignet ist, Lichtstrahlen in Richtung einer ersten Eintrittsseite des Lichtleiters auszusenden, und so, dass die Lichtquelle des zweiten Typs geeignet ist, Lichtstrahlen in Richtung einer zweiten Eintrittsseite, die von der ersten Eintrittsseite verschieden ist, desselben Lichtleiters auszusenden.

15. Lichtmodul nach einem der Ansprüche 1 bis 13, **dadurch gekennzeichnet, dass** die Lichtquellen (130, 140; 230, 240) und der Lichtleiter (150, 250) so angeordnet sind, dass die Lichtquellen des ersten und des zweiten Typs geeignet sind, Lichtstrahlen in Richtung derselben Eintrittsseite (152, 252) des Lichtleiters auszusenden.

## Claims

1. Lighting module (100, 200) for an automotive vehicle, comprising a light guide (150, 200), at least one light-emitting semiconductor component light source of a first type (130, 230), at least one light-emitting semiconductor component light source of a second type (140, 240), the arrangement of the light sources being such that the light sources of the first type (130, 230) and of the second type (140, 240) are capable of emitting light rays in the direction of an entry face (152, 252) of the light guide (150, 200), further comprising a support (110, 210) and a printed circuit board (120, 220) housed on the support (110, 210), the at least one light source of the first type (130, 230) being mounted on the printed circuit board (120, 220),
**characterized in that** the at least one light source of the second type (140, 240) is housed directly on the support (110, 210).

2. Lighting module according to Claim 1, **characterized in that** the printed circuit board (120, 220) comprises at least one through-window (122, 222), giving access to the support (110, 210), and **in that** the light source of the second type (140, 240) is housed on the support at the location corresponding to the window of the printed circuit board.

3. Lighting module according to either of Claims 1 and 2, **characterized in that** the light source of the second type (240) is electrically connected to the printed circuit board (220).

4. Lighting module according to Claim 3, **characterized in that** the connection between the light source of the second type (240) and the printed circuit board (220) is made via bridging by a metal wire (260).

5. Lighting module according to one of Claims 1 to 4, **characterized in that** the light sources of the first and of the second type (230, 240) are supplied with electricity by shared means for controlling the power supply.

6. Lighting module according to one of Claims 1 to 5, **characterized in that** the printed circuit board (120, 220) is fixed to the support (110, 210) by crimping or by bonding.

7. Lighting module according to one of Claims 1 to 6, **characterized in that** the light source of the second type (140, 240) is fixed to the support (110, 210) by bonding.

8. Lighting module according to either of Claims 6 and 7, **characterized in that** the bonding is carried out using a thermally conductive adhesive.

9. Lighting module according to one of Claims 1 to 8, **characterized in that** the support (110, 210) comprises means for dissipating the heat of the module.

10. Lighting module according to Claim 9, **characterized in that** the heat dissipation means comprise aluminium.

11. Lighting module according to one of Claims 1 to 10, **characterized in that** the light source of the first type (130, 230) is capable of emitting light of a first colour, for example the colour amber, and **in that** the light source of the second type (140, 240) is capable of emitting light of a second colour, for example the colour white.

12. Lighting module according to one of Claims 1 to 11, **characterized in that** the light source of the first type (130, 230) is intended to carry out a first lighting function, for example the function of turn indicator, and **in that** the light source of the second type (140, 240) is intended to carry out a second lighting function, for example the function of daytime running lights.

13. Lighting module according to one of Claims 1 to 12, **characterized in that** the light sources (130, 140; 230, 240) are semiconductor element light sources, for example light-emitting diode (LED) light sources.

14. Lighting module according to one of Claims 1 to 13, **characterized in that** the light sources and the light guide are arranged so that the light source of the first type is capable of emitting light rays in the direction of a first entry face of the light guide, and so that the light source of the second type is capable of emitting light rays in the direction of a second entry face, different from the first entry face, of the same light guide.

15. Lighting module according to one of Claims 1 to 13, **characterized in that** the light sources (130, 140; 230, 240) and the light guide (150, 250) are arranged so that the light sources of the first and of the second type are capable of emitting light rays in the direction of one and the same entry face (152, 252) of the light guide.
